# EUROPEAN PATENT SPECIFICATION

(11) **EP 2 151 866 B1**
(45) Date of publication and mention of the grant of the patent: **02.04.2014**
(21) Application number: 09167079.4
(22) Date of filing: 03.08.2009
(51) Int. Cl.: H01L 27/32, H01L 51/56

(54) **Method of depositing light emitting layer of organic EL device and method of manufacturing organic EL device**
Verfahren zur Ablagerung von einer lichtemittierenden Schicht aus einer organischen EL-Vorrichtung und Herstellungsverfahren für die organische EL-Vorrichtung
Procédé de dépôt d'une couche électroluminescente d'un dispositif EL organique et procédé de fabrication d'un dispositif EL organique

(30) Priority: 04.08.2008 KR 20080076111
(43) Date of publication of application: 10.02.2010
(73) Proprietor: Samsung Display Co., Ltd., Yongin-City, Gyeonggi-Do, 446-711 (KR)
(72) Inventor: Lhee, Za-Il, 446-711 Gyunggi-do (KR); Hong, Sang-Mok, 446-711 Gyunggi-do (KR); Lee, Keun-Soo, 446-711 Gyunggi-do (KR)
(74) Representative: Walaski, Jan Filip

(56) References cited:
- JP-A- 2003 231 961
- US-A1- 2006 119 252

## Description

The present embodiments relate to a method of depositing a light emitting layer of an organic electroluminescent (EL) device, a method of manufacturing an organic EL device including the above deposition method, and an organic EL device manufactured by the above manufacturing method.

Organic EL devices that are active type light emitting display devices have drawn attention as one of next generation display devices because of a wide viewing angle, a superior contrast, and a fast response speed. The organic EL device is formed by forming an anode in a predetermined pattern on a glass or other transparent insulation substrate and then sequentially depositing an organic material and a cathode over the anode.

When a voltage is applied to the anode and the cathode of the organic EL device configured as above, a plurality of holes injected from the anode move toward a light emitting layer via a hole transport layer and a plurality of electrons generated by the cathode are injected in the light emitting layer by passing through an electron transport layer. In the light emitting layer, the electrons and the holes are combined and generate excitons. As the excitons move from an exciton state to a ground state, a plurality of organic molecules of the light emitting layer emit light to form an image.

To manufacture an organic EL device capable of presenting a full color scheme, a method of independently depositing subpixels of red (R), green (G), and blue (B) on a substrate using a mask, forming each unit pixel, is generally used. In forming a unit pixel of the organic EL device according to the above method, a slit type shadow mask or a slot type shadow mask is often used.

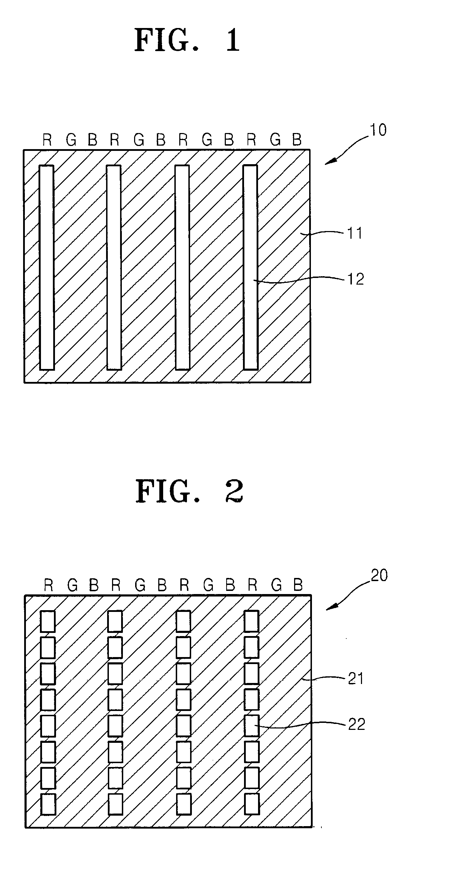

FIG. 1 is a plan view of a slit type unit mask 10. FIG. 2 is a plan view of a slot type unit mask 20. Referring to FIG. 1, the slit type unit mask 10 includes a shield portion 11 and an opening portion 12 in a strip shape. The slit type unit mask 10 is advantageous in that the opening portion 12 is large because the opening portion 12 corresponding to one of the subpixels of R, G, and B, for example, the subpixel R in FIG. 1, is open in a strip shape so that shadowing occurring between upper and lower pixels does not need to be considered. However, since there is no cross rib between the upper and lower pixels, the mask sags due to the weight thereof so that the substrate and the mask can be separated from each other. Furthermore, as the size of a display device increases, the size of the shadow mask increases as well so that the mask sagging phenomenon is deteriorated.

Referring to FIG. 2, the slot type unit mask 20 includes a shield portion 21 and an opening portion 22 having a slot shape corresponding to one of the subpixels of R, G, and B, for example, the subpixel R in FIG. 1. In the slot type unit mask 20, although the mask sagging phenomenon occurring in the slit type unit mask 10 is improved by a cross rib formed across the shield portion 21, the shadowing phenomenon due to the cross rib between the upper and lower pixels is generated so that the opening portion is narrowed.

US 2006/119252 discloses a method of manufacturing a full-colour organic EL panel in which pixels emitting lights of different colours are formed by selectively depositing an organic material on a pixel-by-pixel basis, wherein a deposition process of depositing an organic material for emitting light of at least one colour includes a first step of depositing an organic material for emitting light of at least one colour, using a first mask, on a first group of pixels corresponding to the openings of the first mask, and a second step of depositing an organic material for emitting light of the same colour as the one colour, using a second mask, on a second group of pixels corresponding to openings of the second mask.

JP 2003/231961 discloses a mask used for forming luminescent layer patterns. The mask comprises a laminate of two mask members comprising a first mask member having apertures corresponding to all the patterns to be formed and a second mask member having apertures corresponding to some of the patterns.

The present embodiments provide a method of manufacturing an organic EL device which can prevent a mask sagging phenomenon, reduce the opening area, and improve visibility rate in a light emitting area.

According to an aspect of the present embodiments, there is provided a method of depositing a light emitting layer of an organic EL device as set out in claim 1. Preferred features of this aspect are set out in claims 2 to 8.

According to another aspect of the present embodiments, there is provided a method of manufacturing an organic EL device, the method comprising forming a first electrode layer of a predetermined pattern on an insulating substrate, forming an organic light emitting layer comprising a light emitting layer of a predetermined pattern on the first electrode layer, forming a second electrode layer of a predetermined pattern on the organic light emitting layer, and sealing the outside of the second electrode layer, wherein, the organic light emitting layer is formed by the method as described in anyone of claims 1-8.

The above and other features and advantages of the present embodiments will become more apparent by describing in detail exemplary embodiments thereof with reference to the attached drawings in which:
FIG. 1 is a plan view of a slit type unit mask;
FIG. 2 is a plan view of a slot type unit mask;
FIGS. 3A and 3B illustrate a mask for an organic EL device used in the present embodiments;
FIGS. 4A-4B illustrate a general method of depositing an organic light emitting layer of an organic EL device using the mask of FIGS. 3A and 3B;
FIGS. 5A and 5B are plan views for showing a method of depositing an organic light emitting layer of an organic EL device according to an embodiment, to reduce the inferior visibility due to a neighboring black spot;
FIGS. 6A and 6B are plan views for showing a method of depositing an organic light emitting layer of an organic EL device according to another embodiment, to reduce the inferior visibility due to a neighboring black spot;
FIGS. 7A and 7B are plan views for showing a method of depositing an organic light emitting layer of an organic EL device according to another embodiment, to reduce the inferior visibility due to a neighboring black spot; and
FIGS. 8A and 8B are plan views for showing a method of depositing an organic light emitting layer of an organic EL device according to a modified example of the embodiment of FIGS. 7A and 7B, to reduce the inferior visibility due to a neighboring black spot.

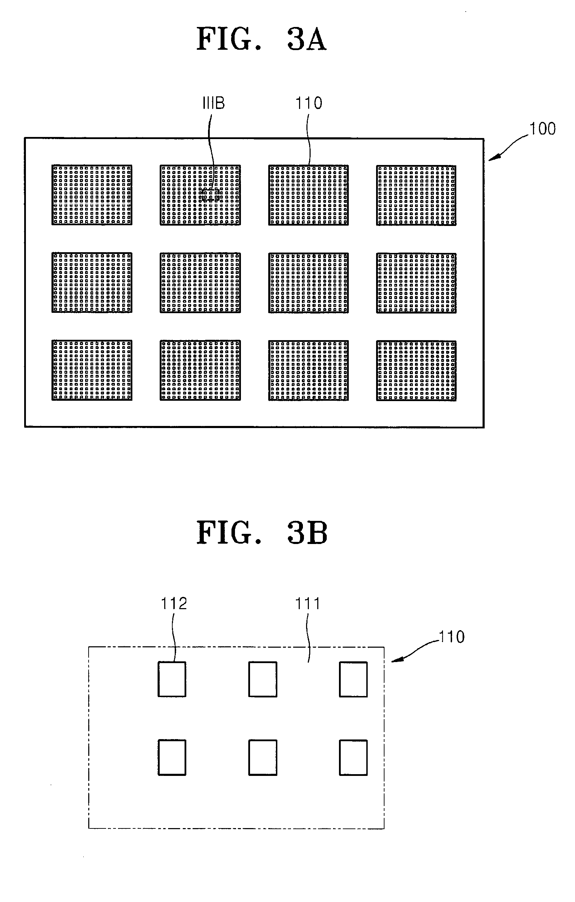

FIGS. 3A and 3B schematically illustrate a mask for an organic EL device used in the present embodiments. Referring to FIG. 3A, a mask 100 for an organic EL device used in the present embodiments includes at least one unit mask 110. Although twelve unit masks 110 are formed on the mask 100 that is a fine metal mask in the drawing, the present embodiments are not limited thereto and the number and arrangement of the unit masks 110 may be variously modified.

The unit mask 110 includes a shield portion 111 and a plurality of opening portions 112 that are patterned, as shown in FIG. 3B. Each of the opening portions 112, which will be described later, includes a plurality of subpixels arranged in a matrix type. In an organic EL device having subpixels of the same color in the same column, the opening portions 112 are formed to correspond to the positions of red (R), green (G), and blue (B) subpixels arranged in an odd-numbered row or an even-numbered row.

Since a rib is formed between upper and lower pixels in the mask 100, a mask sagging phenomenon is improved. Also, since the operation portions 112 are not formed continuously in the neighboring upper and lower pixels, a shadowing phenomenon between the upper and lower pixels is reduced so that a problem related to narrowing of the opening portion of the conventional slot type mask can be prevented.

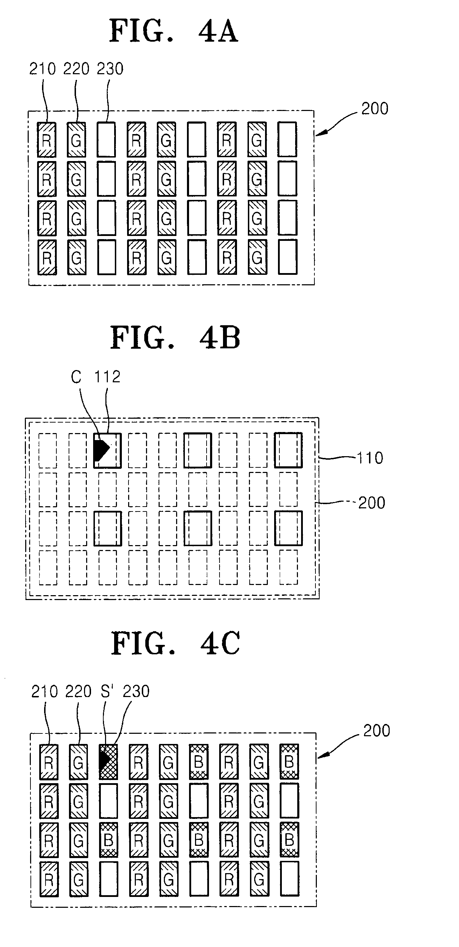

FIGS. 4A-4B illustrate a general method of depositing an organic light emitting layer of an organic EL device using the mask of FIGS. 3A and 3B. Referring to FIG. 4A, a part of an organic EL device is shown in which red (R) and green (G) light emitting layers 210 and 220 are already deposited on an insulating substrate 200 and a blue (B) light emitting layer 230 can be deposited.

In an organic light emitting layer of the organic EL device, unit pixels each combining the red (R), green (G), and blue (B) subpixels are formed in a matrix format. The light emitting layers of the same color are arranged in the same column while the red (R), green (G), and blue (B) light emitting layers are subsequently and alternately arranged in the same row.

Although not illustrated in detail in the drawing, a first electrode layer of a predetermined pattern is formed on the insulating substrate 200 using ITO and red (R), green (G), and blue (B) organic light emitting layers are deposited on the first electrode layer. Also, when the first electrode layer is operated as an anode, a hole injection layer and a hole transport layer may be further provided between the first electrode and the organic light emitting layer. When the second electrode layer is operated as a cathode, an organic film such as an electron injection layer and an electron transport layer may be formed between the second electrode layer and the organic light emitting layer. The organic film may be deposited using an open mask or a fine metal mask that is used in the present embodiment. Any organic film forming materials that are used for a conventional small molecule organic EL device may be used for the organic layer. The layers are deposited in order of the hole injection layer, the hole transport layer, the light emitting layer, the electron transport layer, and the electron injection layer. The structure of layer deposition may be variously modified.

For an active type organic EL device, a plurality of TFTs are electrically connected to each of the first electrodes. When the deposition of the second electrode layer is completed, the active type organic EL device is sealed using a sealing substrate and a terminal that is externally exposed is connected to a drive circuit device so that the organic EL device is completed.

Although in FIG. 4A the red (R) and green (G) light emitting layers 210 and 220 are already deposited, this is merely for the convenience of explanation and thus the deposition sequence of the organic light emitting layer may be changed.

FIG. 4B illustrates a state in which the unit mask 110 and the insulating substrate 200 including an organic EL device are aligned to each other to first deposit the blue (B) light emitting layer 230. Referring to FIG. 4B, the opening portions 112 of the unit mask 110 are arranged to correspond to the positions of blue subpixels arranged in the odd-numbered rows of subpixels where the blue (B) light emitting layers of the organic EL device are to be formed.

As shown in FIG. 4B, in the state in which the unit mask 110 and the insulating substrate 200 having the organic EL device are aligned to each other, an organic light emitting material is deposited by a deposition source (not shown) on the blue subpixels arranged in the odd-numbered rows of the organic EL device. Although in FIG. 4B, the unit mask 110 is arranged on the substrate 200 having the organic EL device for the convenience of explanation, generally, the deposition source is arranged in the lower portion of a deposition chamber (not shown) and the unit mask 110 is arranged above the deposition source. The insulating substrate 200 having the organic EL device is arranged above the unit mask 110.

The mask 100 for an organic EL device may be contaminated by contaminants in the deposition chamber or other environment in the deposition of the organic light emitting layer. In FIG. 4B, a portion of one of the opening portions 112 of the unit mask 110 is contaminated with a contaminant C. The contaminant C may be transferred to a light emitting layer of the organic EL device in the deposition of the organic light emitting layer.

FIG. 4C illustrates a portion of the insulating substrate 200 in which the organic EL device is formed where the blue (B) light emitting layer 230 arranged in the odd-numbered row is first deposited in the alignment state of FIG. 4B. Referring to FIG. 4B, in the organic EL device, not only the red (R) and green (G) light emitting layers 210 and 220 but also the blue (B) light emitting layer 230 arranged on the odd-numbered row is further deposited. A pattern of the contaminant C is transferred to the blue (B) light emitting layer 230 at a position corresponding to each of the opening portions 112 of the unit mask 110 contaminated with the contaminant C so that a first black spot S' is generated. The black spot S' formed on the light emitting layer may deteriorate the display quality or cause irregularity in brightness of the organic EL device.

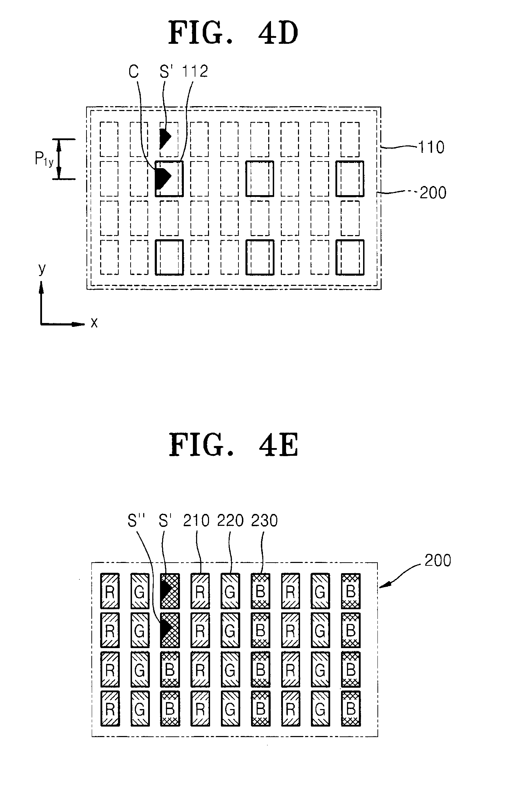

FIG. 4D illustrates a state in which the unit mask 110 and the insulating substrate 200 including an organic EL device are aligned to each other to deposit the blue (B) light emitting layer 230 excluded from the first deposition. Referring to FIG. 4D, the opening portions 112 of the unit mask 110 are moved vertically, that is, in a direction of -y, by a one-pixel pitch P_{1y} from the state of the first deposition and are arranged to correspond to the positions of the blue subpixels arranged in the even-numbered rows, of the subpixels where the blue light emitting layers of the organic EL device are to be formed.

The terms such as the even-numbered or odd-numbered row used in the present specification are used as relative concepts for the convenience of explanation. As shown in FIG. 4A or 4C, the even number and the odd number are divided based on the order of the pixels shown in a portion of the organic EL device including a plurality of unit pixels, however the present embodiments are not limited thereto. Thus, the opening portion of the mask for an organic EL device used for the present embodiment is formed to correspond to the positions of subpixels of the same color that are alternately arranged in a row, of the pixels formed in each row of the organic EL device.

The subpixels arranged in the even-numbered row are deposited into a blue light emitting layer by the deposition source in the state in which the unit mask 110 and the insulating substrate 200 are aligned as above. The contaminant C formed in the opening portions 112 in the first deposition operation is not eliminated and may be transferred to the organic EL device in the second deposition operation.

FIG. 4E illustrates a portion of the insulating substrate 200 in which the organic EL device on which the blue light emitting layer 230 arranged in each even-numbered row is second deposited is formed in the alignment state of FIG. 4D. Referring to FIG. 4E, in addition to the blue light emitting layer arranged in each odd-numbered row during the first deposition, a blue light emitting layer is further arranged in each even-numbered row in the organic EL device. A pattern of the contaminant D is transferred to the blue light emitting layer 230 at a position corresponding to the opening portion 112 of the mask contaminated with the contaminant C so that a second black spot S" is generated.

In a process of continuously depositing organic light emitting layers of the organic EL device in the even-numbered and odd-numbered rows using the mask 100 having the contaminant C, the pattern of the contaminant C is transferred so that the first black spot S' and the second black spot S" are formed in the neighboring upper and lower subpixels of the organic EL device.

However, when a defective pixel including a black spot is formed adjacent to the pixels as described above, inferior visibility increases. Thus, when a light emitting layer is deposited using a mask for an organic EL device in the above method, the mask sagging phenomenon and the decrease of aperture ratio may be solved but a defect rate increases due to the inferior visibility.

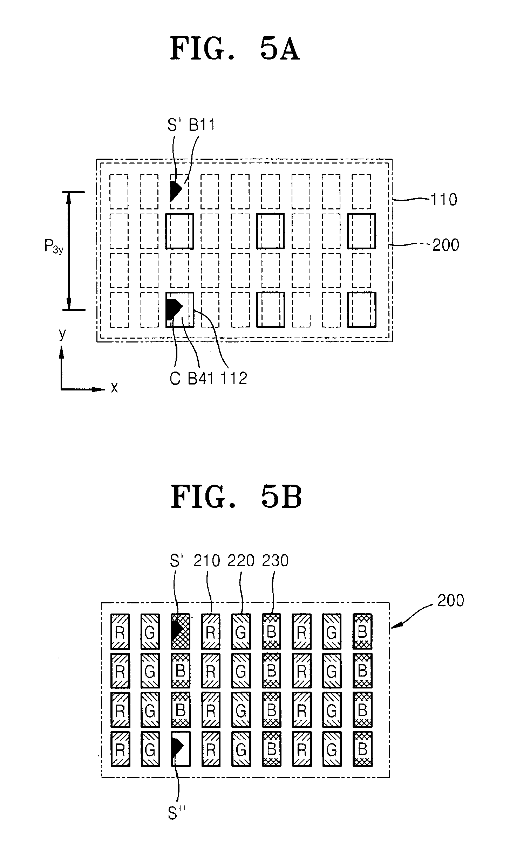

FIGS. 5A and 5B are plan views for explaining a method of depositing an organic light emitting layer of an organic EL device according to an embodiment, to reduce the inferior visibility due to a neighboring black spot. FIG. 5A shows that the insulating substrate 200 including the organic EL device and the unit mask 110 are aligned to each other for the second deposition of the blue light emitting layer in the even-numbered row after the first deposition of the blue light emitting layer in the odd-numbered row is completed.

In the first deposition operation of the blue light emitting layer in the odd-numbered row, since the blue light emitting layer is deposited such that the opening portion 112 of the unit mask 110 having the contaminant C corresponds to a blue subpixel B11 of the unit pixel arranged at the first row and the first column of the organic EL device, the first black spot S' is formed in the blue subpixel B11 arranged at the first row and the first column.

After the first deposition, the opening portions 112 of the unit mask 110 are moved by a three-pixel pitch P_{3y} vertically with respect to the alignment state of the first deposition, and is aligned to correspond to the positions of the subpixels arranged in the even-numbered row of the subpixels where the blue light emitting layer of the organic EL device is to be formed.

The opening portion 112 of the unit mask 110 having the contaminant C corresponds to a blue subpixel B41 of the unit pixel arranged at the fourth row and the first column. The subpixels arranged in the even-numbered row are second deposited into the blue light emitting layer by the deposition source in the state in which the unit mask 110 and the insulating substrate 200 are aligned as above.

Although it is not illustrated in detail in the drawings, to allow the opening portions 112 of the unit mask 110 to have a structure still corresponding to the blue subpixels in the even-numbered row of the organic EL device after the unit mask 110 is moved by the three-pixel pitch P_{3y} vertically in the direction of -y, the unit mask 110 may include more number of the opening portions 112 than the number of the subpixels around the unit mask 110. The opening portions 112 formed around the unit mask 110 are open and used for the deposition of a pixel when the formation of a pixel is needed. Also, the opening portions 112 may prevent the deposition of a pixel through the opening portion 112 by being blocked by a shield (not shown).

FIG. 5B shows a portion of the insulating substrate 200 on which the organic EL device in which the blue light emitting layer arranged in each even-numbered row is second deposited in the alignment state of FIG. 5A is formed. Referring to FIG. 5B, while the first black spot S' formed during the first deposition of the blue light emitting layer is formed on the blue subpixel B11 arranged at the first row and the first column, the second black spot S" formed during the second deposition of the blue light emitting layer is formed on the blue subpixel B41 arranged at the fourth row and the first column. That is, according to the organic deposition method according to the present embodiment, the black spots S' and S" generation positions B11 and B41 are located not adjacent to each other but separated from each other. Thus, the inferior visibility is reduced.

In the above embodiment, although the unit mask 110 is moved by the three-pixel pitch P_{3y} vertically in the direction of -y based on the first deposition during the second deposition, the present embodiments are not limited thereto. That is, the unit mask 110 may be moved vertically by a variety of distances, for example, a five-pixel pitch, a seven-pixel pitch,..., and a (2N+1) pixel pitch, where N is a natural number. Also, the vertical movement is a relative one so that the unit mask 110 may be moved by a (2N+1) pixel pitch substantially parallelly in a direction of +y.

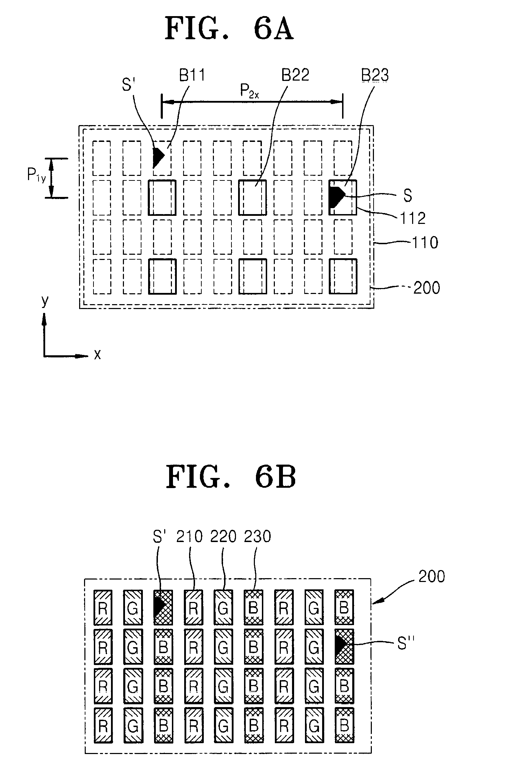

FIGS. 6A and 6B are plan views for explaining a method of depositing an organic light emitting layer of an organic EL device according to another embodiment, to reduce the inferior visibility due to a neighboring black spot. FIG. 6A shows that the insulating substrate 200 including the organic EL device and the unit mask 110 are aligned to each other for the second deposition of the blue light emitting layer in the even-numbered row after the first deposition of the blue light emitting layer in the odd-numbered row is completed.

In the first deposition operation of the blue light emitting layer in the odd-numbered row, since the blue light emitting layer is deposited such that the opening portion 112 of the unit mask 110 having the contaminant C corresponds to the blue subpixel B11 of the unit pixel arranged at the first row and the first column, the first black spot S' is formed in the blue subpixel B11 arranged at the first row and the first column.

After the first deposition, the opening portions 112 of the unit mask 110 are moved by the one-pixel pitch P_{1y} vertically in the direction of -y and by a two-pixel pitch P₂ₓ in a direction of +x with respect to the alignment state of the first deposition, and is aligned to correspond to the positions of the subpixels arranged in the even-numbered row of the subpixels where the blue light emitting layer of the organic EL device is to be formed.

The opening portion 112 of the unit mask 110 having the contaminant C corresponds to a blue subpixel B23 of the unit pixel arranged at the second row and the third column. The subpixels arranged in the even-numbered row are second deposited into the blue light emitting layer by the deposition source in the state in which the unit mask 110 and the insulating substrate 200 are aligned as above.

Although it is not illustrated in detail in the drawings, to allow the opening portions 112 of the unit mask 110 to have a structure still corresponding to the blue subpixels in the even-numbered row of the organic EL device after the unit mask 110 is moved by the one-pixel pitch P_{1y} vertically in the direction of -y and by the two-pixel pitch P₂ₓ vertically in the direction of +x, the unit mask 110 may include more number of the opening portions 112 than the number of the subpixels around the unit mask 110. The opening portions 112 formed around the unit mask 110 are open and used for the deposition of a pixel when the formation of a pixel is needed. Also, the opening portions 112 may prevent the deposition of a pixel through the opening portion 112 by being blocked by a shield (not shown).

FIG. 6B illustrates a portion of the insulating substrate 200 in which the organic EL device on which the blue light emitting layer 230 arranged in each even-numbered row is second deposited is formed in the alignment state of FIG. 6A. Referring to FIG. 6B, although the first black spot S' formed during the first deposition of the blue light emitting layer is formed in the blue subpixel B11 of the unit pixel arranged at the first row and the first column, the second black spot S" formed during the second deposition of the blue light emitting layer is formed in the blue subpixel B23 arranged at the second row and the third column. That is, according to the organic deposition method according to the present embodiment, the black spots S' and S" generation positions B11 and B23 are located not adjacent to each other but separated from each other. Thus, the inferior visibility is reduced.

In the above embodiment, although the unit mask 110 is moved by the one-pixel pitch P_{1y} vertically in the direction of -y and by the two-pixel pitch P₂ₓ horizontally during the second deposition, the present embodiments are not limited thereto. For example, when the unit mask 110 is moved vertically by a one-pixel pitch and horizontally by a one-pixel pitch, the second black spot is formed at a position B22. However, since the second black spot is not adjacent to the first black spot, the inferior visibility is reduced. Accordingly, the present embodiments may be embodied by a combination of moving the mask by an odd-numbered pixel pitch over one pixel pitch (2N-1, N is a natural number) vertically in the direction of -y or +y and moving the mask by a one-pixel or more pitch horizontally in the direction or -x or +x.

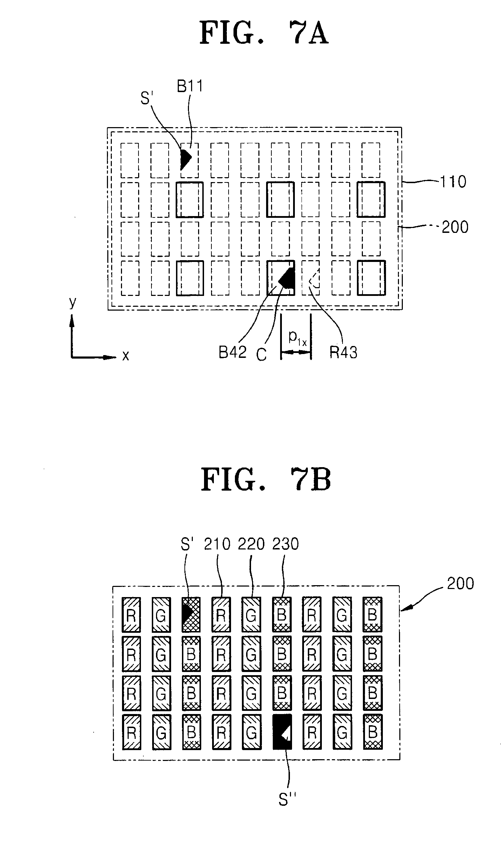

FIGS. 7A and 7B are plan views for explaining a method of depositing an organic light emitting layer of an organic EL device according to another embodiment, to reduce the inferior visibility due to a neighboring black spot. FIG. 7A illustrates that the unit mask 110 and the insulating substrate 200 having an organic EL device are aligned to each other for the second deposition of the blue light emitting layer in the even-numbered row after the first deposition of the blue light emitting layer in the odd-numbered row is completed.

Since, during the first deposition of the blue light emitting layer in the odd-numbered row, the blue light emitting layer is deposited such that the opening portion 112 of the unit mask 110 having the contaminant C corresponds to the blue subpixel B11 arranged at the first row and the first column of the organic EL device, the first black spot S' is formed at the blue subpixel B11 of the unit pixel arranged at the first row and the first column.

After the first deposition, the opening portions 112 of the unit mask 110 are rotated by 180° around the center of the mask 100 in the alignment state of the first deposition and then moved by a one-subpixel pitch P₁ₓ horizontally in the direction of -x. The one-subpixel pitch equals a 1/3 pixel pitch.

In the present embodiment, it is assumed that the center of the unit mask 110 matches the center of the mask 100 for an organic EL device in FIG. 7A, however the present embodiments are not limited hereto. In this state, the opening portion 112 of the unit mask 110 having the contaminant C corresponds to a red subpixel R43 of a pixel arranged at the fourth row and the third column by the 180° rotation. Next, by moving by the one-subpixel pitch P₁ₓ in the direction of -x, the opening portion 112 of the unit mask 110 having the contaminant C corresponds to the blue pixel B42 of the pixel arranged at the fourth row and the second column. Accordingly, in the state in which the unit mask 110 and the insulating substrate 200 are aligned to each other, the subpixels arranged in the even-numbered row are second deposited by the deposition source into a blue light emitting layer.

In the above-described embodiment, it is assumed that one unit mask is formed on the mask 100 for an organic EL device (please refer to FIG. 3A), however, the present embodiments are not limited thereto. Although the above description focuses on the movement of the unit mask 100 for the convenience of explanation, actual unit masks are subject to the movement of the mask 100 for an organic EL device including the unit masks. Thus, when the mask 100 for an organic EL device including a plurality of unit masks are rotated, the opening portion of the unit mask having a contaminant is positioned in an area of a subpixel of another light emitting device, unlike the illustrations of the drawings. However, in such a case, by moving the unit mask 100 by the one-subpixel pitch in the direction of -x, the opening portion of the unit mask having a contaminant corresponds to a blue pixel arranged in another even-numbered row.

FIG. 7B illustrates a portion of the insulating substrate 200 in which the organic EL device on which the blue light emitting layer 230 arranged in each even-numbered row is second deposited is formed in the alignment state of FIG. 7A. Referring to FIG. 7B, although the first black spot S' formed during the first deposition of the blue light emitting layer is formed in the blue subpixel B11 of the unit pixel arranged at the first row and the first column, the second black spot S" formed during the second deposition of the blue light emitting layer is formed in the blue subpixel B42 arranged at the fourth row and the second column. That is, according to the organic deposition method according to the present embodiment, the black spots S' and S" generation positions B11 and B42 are located not adjacent to each other but separated from each other. Thus, the inferior visibility is reduced.

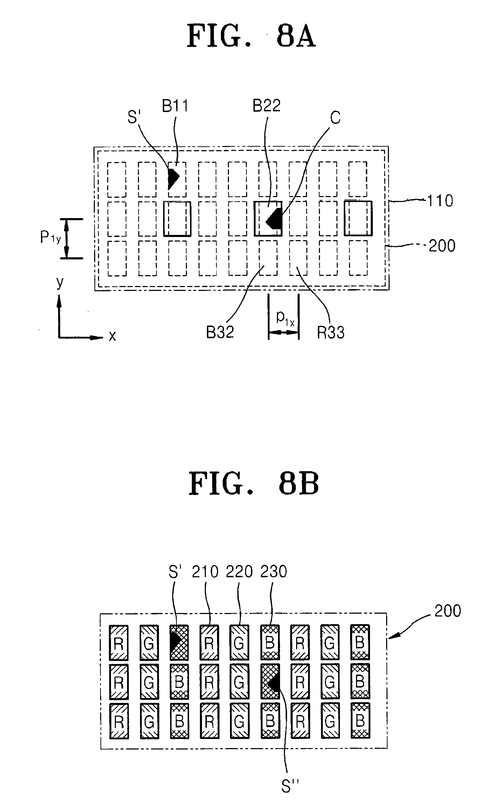

FIGS. 8A and 8B are plan views for explaining a method of depositing an organic light emitting layer of an organic EL device according to a modified example of the embodiment of FIGS. 7A and 7B, to reduce the inferior visibility due to a neighboring black spot. In the embodiment of FIGS. 7A and 7B, when the opening portions 112 having the contaminant C are rotated by 180° around the mask 100 and pixels of an even-numbered row, for example, two rows in the present embodiment, are arranged between the opening portions 112 having the contaminant C before and after the 180° rotation, a blue subpixel in the even-numbered row is the position where the opening portions 112 are horizontally moved by the one-pixel pitch after the rotation.

However, when the opening portions 112 having the contaminant C are rotated by 180° around the mask 100 and pixels of an odd-numbered row, for example, one row, are arranged between the opening portions 112 having the contaminant C before and after the 180° rotation, the position where the opening portions 112 are horizontally moved by the one-pixel pitch after the rotation is a blue subpixel in the odd-numbered row so that the opening portions 112 needs to be further moved by the one-pixel pitch vertically.

FIG. 8A illustrates that the unit mask 110 and the insulating substrate 200 having an organic EL device are aligned to each other for the second deposition of the blue light emitting layer in the even-numbered row after the first deposition of the blue light emitting layer in the odd-numbered row is completed. Since, during the first deposition of the blue light emitting layer in the odd-numbered row, the blue light emitting layer is deposited such that the opening portion 112 of the unit mask 110 having the contaminant C corresponds to the blue subpixel B11 arranged at the first row and the first column of the organic EL device, the first black spot S' is formed at the blue subpixel B11 of the unit pixel arranged at the first row and the first column.

After the first deposition, the opening portions 112 of the unit mask 110 are rotated by about 180° around the center of the mask 100 in the alignment state of the first deposition and then moved by the one-subpixel pitch P₁ₓ horizontally in the direction of -x. The one-subpixel pitch equals a 1/3 pixel pitch.

In the present embodiment, it is assumed that the center of the unit mask 110 matches the center of the mask 100 for an organic EL device in FIG. 8A. In this state, the opening portion 112 of the unit mask 110 having the contaminant C corresponds to a red subpixel R33 of a pixel arranged at the third row and the third column by the 180° rotation. Next, by being moved by a one-subpixel pitch in the direction of -x, the opening portion 112 of the unit mask 110 having the contaminant C corresponds to the blue pixel B32 of the pixel arranged at the third row and the second column. In the present embodiment, however, since the blue pixel B32 is a blue light emitting layer arranged in an odd-numbered row, the mask is further moved by the one-pixel pitch P_{1y} vertically in the direction of +y to arrive at the blue subpixel B22 at the second row and the second column. Also, although it is not illustrated in the drawing, the mask may be further moved by the one-pixel pitch in the direction of -y.

FIG. 8B illustrates a portion of the insulating substrate 200 in which the organic EL device on which the blue light emitting layer 230 arranged in each even-numbered row is second deposited is formed in the alignment state of FIG. 8A. Referring to FIG. 8B, although the first black spot S' formed during the first deposition of the blue light emitting layer is formed in the blue subpixel B11 of the unit pixel arranged at the first row and the first column, the second black spot S" formed during the second deposition of the blue light emitting layer is formed in the blue subpixel B22 arranged at the second row and the second column. That is, according to the organic deposition method according to the present embodiment, the black spots S' and S" generation positions B11 and B22 are located not adjacent to each other but separated from each other. Thus, the inferior visibility is reduced.

As described above, according to the method of depositing a light emitting layer using a mask for an organic EL device according to the present embodiments, the mask sagging and the opening portion reduction are prevented and the inferior visibility due to the generation of a neighboring black spot may be reduced.

The invention may, however, be embodied in many different forms and should not be construed as being limited to the embodiments set forth herein; rather, these embodiments are provided so that this disclosure will be thorough and complete, and will fully convey the concept of the invention to those skilled in the art. While the present embodiments have been particularly shown and described with reference to exemplary embodiments thereof, it will be understood by those of ordinary skill in the art that various changes in form and details may be made therein without departing from the present invention as defined by the following claims.

## Claims

1. A method of depositing a light emitting layer (210, 220, 230) of an organic EL device in which a subpixel combination having a plurality of different colors is set as a unit pixel, a plurality of subpixels are sequentially and alternately arranged in a row direction, and a plurality of subpixels of the same color are arranged in a column direction, the method comprising:
a first deposition step comprising depositing the light emitting layer (210, 220, 230) using a mask (110) having a plurality of opening portions (112) corresponding to positions of the subpixels of the same color arranged in either of the odd-numbered rows or even-numbered rows of the subpixels; and
a second deposition step comprising depositing the light emitting layer by moving the mask to deposit the light emitting layer at subpixels of the same color as the first deposition step and arranged in the other of the odd-numbered rows or the even-numbered rows, such that the same opening portion of the mask is not used for depositing the light emitting layer in two adjacent subpixels in the first and second deposition steps.

2. The method of claim 1, wherein the subpixels comprise different colors comprising at least one of red (R), green (G), and blue (B) subpixels.

3. The method of claim 1 or 2, wherein the second deposition step is performed by moving the mask (110) in the column direction by a (2N+1) pixel pitch, wherein N is a natural number, N ≠ O.

4. The method of claim 1 or 2, wherein the second deposition step is performed by moving the mask (110) aligned in the first deposition step by a (2N-1) pixel pitch in the column direction, and by an M-pixel pitch or more in the row direction, wherein N and M are natural numbers, N ≠ O, M ≠ O.

5. The method of claim 2, wherein a unit pixel consists of a red, a green and a blue subpixel and wherein the second deposition step is performed by rotating the mask aligned in the first deposition step by 180° around the center of the mask (100) in the alignment state of the first deposition and moving the mask by one subpixel pitch in the row direction if it is required to ensure that the deposition in the second deposition step is for subpixels of the same color as the first deposition step.

6. The method of claim 2, wherein a unit pixel consists of a red, a green and a blue subpixel and wherein the second deposition step is performed by rotating the mask (110) aligned in the first deposition step by 180° around the center of the mask (100) in the alignment state of the first deposition and moving the mask (110) by a one pixel pitch vertically in the column direction, and moving the mask by one subpixel pitch in the row direction if it is required to ensure that the deposition in the second deposition step is for subpixels of the same color as the first deposition step.

7. The method of any one of the preceding claims, wherein the mask (110) having the opening portions (112) is used for independently depositing each of the subpixels of different colors.

8. The method of any one of the preceding claims, wherein the mask (110) having the opening portions (112) is a fine metal mask.

9. A method of manufacturing an organic EL device, in which a subpixel combination having a plurality of different colors is set as a unit pixel, a plurality of subpixels are sequentially and alternately arranged in a row direction, and a plurality of subpixels of the same color are arranged in a column direction, the method comprising:
forming a first electrode layer of a predetermined pattern on an insulating substrate (200);
forming an organic light emitting layer comprising a light emitting layer (210, 220, 230) of a predetermined pattern on the first electrode layer;
forming a second electrode layer of a predetermined pattern on the organic light emitting layer; and
sealing the outside of the second electrode layer,
wherein the organic light emitting layer is formed by the method of any one of the preceding claims.

## Patentansprüche

1. Verfahren zur Ablagerung einer lichtemittierenden Schicht (210, 220, 230) aus einer organischen EL-Vorrichtung, in der eine Subpixel-Kombination mit einer Vielzahl verschiedener Farben als ein Einheitspixel festgelegt ist, wobei eine Vielzahl von Subpixeln sequenziell und abwechselnd in einer Reihenrichtung angeordnet ist, und eine Vielzahl von Subpixeln der gleichen Farbe in einer Spaltenrichtung angeordnet ist, wobei das Verfahren umfasst:
einen ersten Ablagerungsschritt, der die Ablagerung der lichtemittierenden Schicht (210, 220, 230) unter Verwendung einer Maske (110) umfasst, die eine Vielzahl von Öffnungsabschnitten (112) aufweist, die Positionen der Subpixel der gleichen Farbe entsprechen, die in entweder den ungeradzahligen Reihen oder geradzahligen Reihen der Subpixel angeordnet sind; und
einen zweiten Ablagerungsschritt, der die Ablagerung der lichtemittierenden Schicht durch Verschieben der Maske umfasst, um die lichtemittierende Schicht auf Subpixel der gleichen Farbe wie der erste Ablagerungsschritt abzulagern und in der anderen der ungeradzahligen Reihen oder den geradzahligen Reihen derartig angeordnet ist, dass der gleiche Öffnungsabschnitt der Maske nicht zur Ablagerung der lichtemittierenden Schicht in zwei angrenzende Subpixel bei den ersten und zweiten Ablagerungsschritten verwendet wird.

2. Verfahren nach Anspruch 1, wobei die Subpixel verschiedene Farben umfassen, die zumindest eins von roten (R), grünen (G) und blauen (B) Subpixeln umfassen.

3. Verfahren nach Anspruch 1 oder 2, wobei der zweite Ablagerungsschritt durch Verschieben der Maske (110) in der Spaltenrichtung durch eine (2N+1) Pixelteilung ausgeführt wird, wobei N eine natürliche Zahl, N≠0 ist.

4. Verfahren nach Anspruch 1 oder 2, wobei der zweite Ablagerungsschritt durch Verschieben der Maske (110) ausgeführt wird, die beim ersten Ablagerungsschritt durch eine (2N-1) Pixelteilung in der Spaltenrichtung und durch eine M-Pixelteilung oder mehr in der Reihenrichtung ausgerichtet ist, wobei N und M natürliche Zahlen, N≠0, M≠0 sind.

5. Verfahren nach Anspruch 2, wobei ein Einheitspixel aus einem roten, einem grünen und einem blauen Subpixel besteht und, wobei der zweite Ablagerungsschritt durch Rotieren der im ersten Ablagerungsschritt ausgerichteten Maske um 180° um das Zentrum der Maske (100) im Ausrichtungszustand der ersten Ablagerung und Verschieben der Maske um eine Subpixel-Teilung in der Reihenrichtung ausgeführt wird, wenn dies erforderlich ist, sicherzustellen, dass die Ablagerung beim zweiten Ablagerungsschritt für Subpixel der gleichen Farbe wie beim ersten Ablagerungsschritt ist.

6. Verfahren nach Anspruch 2, wobei ein Einheitspixel aus einem roten, einem grünen und einem blauen Subpixel besteht und, wobei der zweite Ablagerungsschritt durch Rotieren der im ersten Ablagerungsschritt ausgerichteten Maske (110) um 180° um das Zentrum der Maske (100) beim Ausrichtungszustand der ersten Ablagerung und Verschieben der Maske (110) um eine Pixelteilung vertikal in der Spaltenrichtung, und das Verschieben der Maske um eine Subpixel-Teilung in der Reihenrichtung ausgeführt wird, wenn dies erforderlich ist, sicherzustellen, dass die Ablagerung beim zweiten Ablagerungsschritt für Subpixel der gleichen Farbe wie beim ersten Ablagerungsschritt ist.

7. Verfahren nach einem beliebigen der vorangehenden Ansprüche, wobei die Maske (110) mit den Öffnungsabschnitten (112) zum unabhängigen Ablagern jedes der Subpixel verschiedener Farben verwendet wird.

8. Verfahren nach einem beliebigen der vorangehenden Ansprüche, wobei die Maske (110) mit den Öffnungsabschnitten (112) eine feine Metallmaske ist.

9. Herstellungsverfahren für eine organische EL-Vorrichtung, bei der eine Subpixel-Kombination mit einer Vielzahl verschiedener Farben als ein Einheitspixel festgelegt ist, wobei eine Vielzahl von Subpixeln sequenziell und abwechselnd in einer Reihenrichtung angeordnet ist, und eine Vielzahl von Subpixeln der gleichen Farbe in einer Spaltenrichtung angeordnet ist, wobei das Verfahren umfasst:
Bilden einer ersten Elektrodenschicht eines vorgegebenen Musters auf einem isolierenden Substrat (200);
Bilden einer organischen lichtemittierenden Schicht, die eine lichtemittierende Schicht (210, 220, 230) eines vorgegebenen Musters auf der ersten Elektrodenschicht umfasst;
Bilden einer zweiten Elektrodenschicht eines vorgegebenen Musters auf der organischen lichtemittierenden Schicht; und
Versiegeln der Außenseite der zweiten Elektrodenschicht,
wobei die organische lichtemittierende Schicht durch das Verfahren eines beliebigen der vorangehenden Ansprüche gebildet ist.

## Revendications

1. Procédé destiné à déposer une couche électroluminescente (210, 220, 230) d'un dispositif EL organique dans lequel une combinaison de sous-pixels ayant une pluralité de différentes couleurs est définie comme étant une unité pixel, une pluralité de sous-pixels étant agencée de façon séquentielle et alternante suivant un sens Rangée, et une pluralité de sous-pixels de la même couleur étant agencée suivant un sens Colonne, le procédé comprenant :
une première étape de dépôt englobant le dépôt de la couche électroluminescente (210, 220, 230) grâce à l'utilisation d'un masque (110) ayant une pluralité de portions ouvrantes (112) lesquelles correspondent à des positions de sous-pixels de la même couleur agencés dans l'une des rangées suivantes, à savoir les rangées à nombre impair ou les rangées à nombre pair des sous-pixels ; et
une deuxième étape de dépôt englobant le dépôt de la couche électroluminescente grâce au déplacement du masque afin de déposer la couche électroluminescente au niveau de sous-pixels ayant la même couleur que la première étape de dépôt, et agencés dans l'autre des rangées suivantes, à savoir les rangées à nombre impair ou les rangées à nombre pair, de sorte que la même portion ouvrante du masque ne soit pas utilisée pour déposer la couche électroluminescente dans deux sous-pixels adjacents lors des première et deuxième étapes de dépôt.

2. Procédé selon la revendication 1, les sous-pixels qui comportent des couleurs différentes comprenant au moins l'un des sous-pixels suivants, à savoir un sous-pixel rouge (R), un sous-pixel vert (G) et un sous-pixel bleu (B).

3. Procédé selon la revendication 1 ou 2, la deuxième étape de dépôt étant réalisée grâce au déplacement du masque (110) dans le sens Colonne d'un pas de pixel (2N+1), cas dans lequel N est un nombre naturel, N ≠ 0.

4. Procédé selon la revendication 1 ou 2, la deuxième étape de dépôt étant réalisée grâce au déplacement du masque (110), aligné lors de la première étape de dépôt, d'un pas de pixel (2N-1) dans le sens Colonne, et d'un pas de M-pixel, ou davantage, dans le sens Rangée, cas dans lequel N et M sont des nombres naturels, N ≠ 0, M ≠ 0.

5. Procédé selon la revendication 2, une unité pixel se composant d'un sous-pixel rouge, d'un sous-pixel vert et d'un sous-pixel bleu, et la deuxième étape de dépôt étant réalisée grâce à la rotation du masque, aligné lors de la première étape de dépôt, sur 180° autour du centre du masque (100) dans l'état d'alignement du premier dépôt, et grâce au déplacement du masque d'un pas de sous-pixel suivant le sens Rangée, s'il est nécessaire de s'assurer que le dépôt lors de la deuxième étape de dépôt concerne des sous-pixels ayant la même couleur que la première étape de dépôt.

6. Procédé selon la revendication 2, une unité pixel se composant d'un sous-pixel rouge, d'un sous-pixel vert et d'un sous-pixel bleu, et la deuxième étape de dépôt étant réalisée grâce à la rotation du masque (110), aligné lors de la première étape de dépôt, sur 180° autour du centre du masque (100) dans l'état d'alignement du premier dépôt, et grâce au déplacement du masque (110) d'un pas de pixel dans le plan vertical dans le sens Colonne, et grâce au déplacement du masque d'un pas de sous-pixel suivant le sens Rangée, s'il est nécessaire de s'assurer que le dépôt lors de la deuxième étape de dépôt concerne des sous-pixels ayant la même couleur que la première étape de dépôt.

7. Procédé selon l'une quelconque des revendications précédentes, le masque (110) avec les portions ouvrantes (112) étant utilisé pour déposer de façon indépendante chacun des sous-pixels de différentes couleurs.

8. Procédé selon l'une quelconque des revendications précédentes, le masque (110) avec les portions ouvrantes (112) étant un masque en métal fin.

9. Procédé permettant de fabriquer un dispositif EL organique, dans lequel une combinaison de sous-pixels ayant une pluralité de différentes couleurs est définie comme étant une unité pixel, une pluralité de sous-pixels est agencée de façon séquentielle et alternante suivant un sens Rangée, et une pluralité de sous-pixels de la même couleur est agencée suivant un sens Colonne, le procédé comprenant les opérations consistant à :
former une première couche d'électrode, d'un motif prédéterminé, sur un substrat isolant (200) ;
former une couche électroluminescente organique comportant une couche électroluminescente (210, 220, 230), d'un motif prédéterminé, sur la première couche d'électrode ;
former une deuxième couche d'électrode, d'un motif prédéterminé, sur la couche électroluminescente organique ; et
étanchéifier la face externe de la deuxième couche d'électrode,
cas dans lequel la couche électroluminescente organique est formée grâce au procédé selon l'une quelconque des revendications précédentes.
